# EUROPEAN PATENT SPECIFICATION

(11) **EP 2 736 809 B1**
(45) Date of publication and mention of the grant of the patent: **06.04.2016**
(21) Application number: 12817671.6
(22) Date of filing: 21.05.2012
(51) Int. Cl.: B65B 31/00, B65D 81/18, A45C 13/00, A45C 11/00, A45C 11/22, A45C 13/02

(54) **PRESSURIZED WATERPROOF CASE FOR ELECTRONIC DEVICE**
UNTER DRUCK STEHENDES WASSERDICHTES GEHÄUSE FÜR EINE ELEKTRONISCHE VORRICHTUNG
BOÎTIER SOUS PRESSION ÉTANCHE À L'EAU POUR DISPOSITIF ÉLECTRONIQUE

(30) Priority: 28.07.2011 US 201113193295; 01.08.2011 WO PCT/US2011/046085
(43) Date of publication of application: 04.06.2014
(73) Proprietor: King Abdullah University of Science and Technology, Thuwal 23955-6900 (SA)
(72) Inventor: BERUMEN, Michael, Thuwal 23955 (SA)
(74) Representative: D Young & Co LLP
(86) International application number: PCT/US2012/038822
(87) International publication number: WO 2013/015866

(56) References cited:
- US-A- 4 465 189
- US-A- 4 771 299
- US-A1- 2007 215 663
- US-A1- 2010 310 194
- US-B2- 7 263 032
- US-B2- 7 535 799
- BLOGGER.: 'Diving Apps for iPad owners.' 28 May 2011, page PG. 1 AND PG. 3, XP055143197 Retrieved from the Internet: <URL:http://scubadiverlife.com/2011/05/28/d iving-apps-for-ipad-owners/> [retrieved on 2012-07-12]

## Description

### CLAIM FOR PRIORITY

This application claims priority to U.S. Patent Application No. 13/193,295, filed July 28, 2011, and International Application No. PCT/US2011/046085, filed on August 1, 2011.

### FIELD OF THE INVENTION

The present invention relates generally to cases, containers, and the like, and particularly to a pressurized waterproof case for an electronic device, and particularly to a case that permits the use of a touch-screen electronic device contained therein while underwater, e.g., while scuba diving.

### DESCRIPTION OF THE RELATED ART

Scuba divers often find it necessary to take notes or to record information while underwater. Examples include training, where an instructor may write notes or messages for students (or students may communicate with their instructor in the same manner), and commercial divers who need to communicate with other divers during a working dive. One area in which the recording of information underwater is absolutely critical is in the field of underwater research. Marine scientists and researchers must often take notes, label samples that have been collected, fill in data sheets, and record other information. This is conventionally done by using a standard pencil on waterproof paper, which has been found to be workable in years of practice.

While this means of underwater communication and information collecting may be acceptable for transient information that is not of permanent value, it leaves much to be desired as a method of recording information permanently. When the information is to be made as a permanent record, the researcher or scientist typically makes notes at the site using waterproof paper and pencil, as noted further above. These rough notes are later transcribed into a more permanent record, and/or recorded in a computer database or other suitable program. Aside from the additional time that this requires, one problem that can occur at this point is the entry of an error or errors when transcribing from the original notes to the more permanent record. Even if the original notes were absolutely accurate, it is still very easy to introduce some error(s) inadvertently during the transcription, particularly if a large amount of data is being transcribed.

As a result, scientists, researchers, and others who have occasion to work underwater have long desired some means of making a permanent record during the initial step of recording data underwater. The relatively recent development of various forms of tablet computers, and particularly touch-screen devices, such as the Apple iPad®, has enabled persons working on land to accomplish such note taking and data entry directly into such devices, thereby eliminating the step of hand-written notes and the like. However, such computer devices cannot be used underwater without suitable protection from the elements.

One solution that has been attempted in the past is merely to insert the computer or electronic device into a flexible clear plastic bag or the like that can be sealed to prevent the entry of water into the bag and electronic device (see US 2010/0310194). This may be an acceptable solution for such devices for protecting them from the elements, e.g., on the beach or ski slope, or perhaps at a dusty construction site or in inclement weather, but it is unworkable for a touch-screen device to be used underwater. Water pressure at depths routinely encountered by scuba divers and snorkelers bears against the protective plastic bag or container, and in turn bears directly over the entire surface of the computer, including the touch screen. This results in the screen being unable to distinguish a localized touch for the purpose of data entry or the like, rendering the touch-screen device useless as a tool in an underwater environment at any appreciable depth, even when the electronic circuits are protected from the water.

Thus, a pressurized waterproof case for an electronic device solving the aforementioned problems is desired.

### SUMMARY OF THE INVENTION

The above problems are solved by providing a fluid-tight case according to claim 1. A pressurized waterproof case for an electronic device is adapted particularly for the protection and use of a touch-screen tablet computer, or other similar device, in an underwater environment. In one example, the case can be formed from rigid portions and a transparent, flexible membrane or sheet forming one side or surface of the device. Alternatively, the rigid portions of the case may be formed as a unitary, monolithic structure by injection molding, blow molding, or other plastics manufacturing processes, and the transparent membrane or sheet forming one side or surface of the device may be joined and sealed thereto by adhesive, ultrasonic welding, or other joining processes known in the art. The rigid portions or unitary case can be transparent, translucent, or opaque. A removable hatch, cover, or the like may be provided in one of the rigid portions or case, or may comprise one of the rigid portions. The hatch or cover includes a seal to assure that water cannot enter the case. The hatch or cover is of sufficient size to allow a touch-screen computer or similar device to be installed within and removed from the case as desired.

The case is fluid-tight. A source of pressurized air or other gas is provided to pressurize the interior of the case slightly higher than ambient pressure. This assures that the flexible panel or membrane overlying the touch screen is not pressed against the touch screen due to external water pressure higher than the pressure within the case. Such a condition would render the touch screen computer unusable due to the uniform pressure developed over the entire screen as the higher external pressure pressed against the flexible membrane overlying the screen, causing the flexible membrane to make contact with the screen. The slightly higher than ambient pressure provided within the case permeates the electronic device within the case to equalize the pressure internal and external to the electronic device within the case, and specifically separates the flexible membrane from the surface of the touch screen. Thus, the diver or other party using the device may apply touch pressures to various areas of the touch screen through the flexible membrane to operate the device conventionally while at some depth underwater.

In one example, the source of pressurized gas for the device may comprise a small gas cartridge (e.g., CO₂, etc.) removably connected to the case through an on/off or regulator valve, or may comprise a line from an external source of pressure, e.g., the diver's breathing air supply, and conventional and appropriate pressure regulation and safety shutoff means may also be provided. An overpressure relief valve may also be provided in the case.

These and other features of the present invention will become readily apparent upon further review of the following specification and drawings.

### BRIEF DESCRIPTION OF THE DRAWINGS

Fig. 1 is an environmental, perspective view of a pressurized waterproof case for an electronic device according to the present invention, illustrating the case in use in an underwater environment.
Fig. 2 is a perspective view of an exemplary embodiment of a pressurized waterproof case for an electronic device according to the present invention, shown with the case closed and with a touch-screen electronic device contained therein.
Fig. 3 is a partially exploded perspective view of an alternative embodiment of a pressurized waterproof case for an electronic device according to the present invention, showing the end panel removed for accessing the interior of the device and showing an alternative source of pressurization.

Similar reference characters denote corresponding features consistently throughout the attached drawings.

### DETAILED DESCRIPTION OF THE PREFERRED EMBODIMENTS

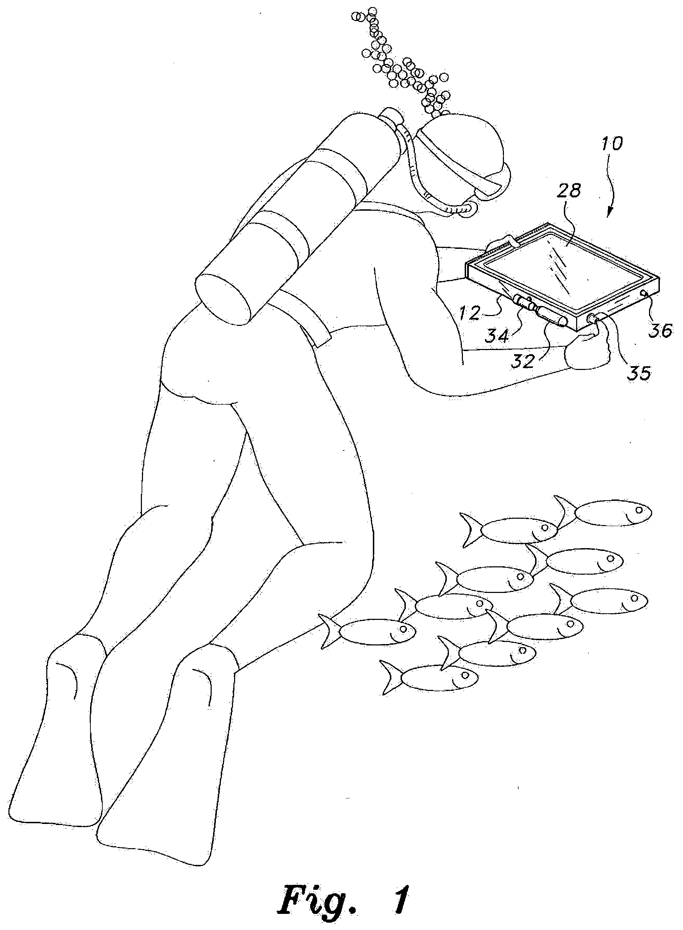

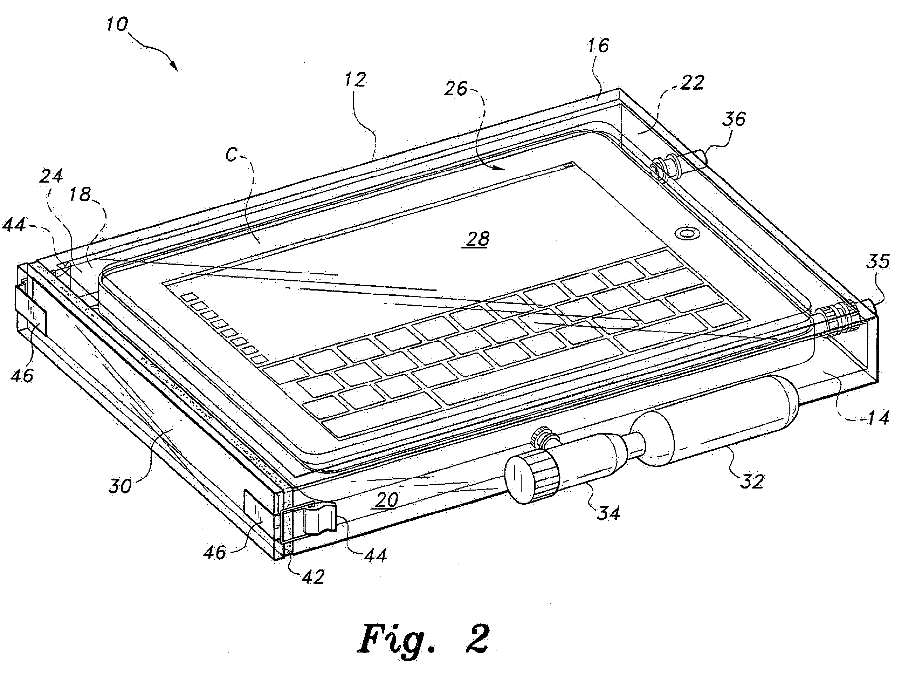

The pressurized waterproof case for an electronic device enables a diver to protect a touch-screen computer device while underwater, and enables the diver to use the device as desired in the underwater environment. Fig. 1 of the drawings provides an environmental view of the pressurized waterproof case for an electronic device 10 in use during a dive, with reference being made as well to the perspective view of the exemplary embodiment of the case in Fig. 2 for a more detailed view.

The case 10 includes a relatively thin, flat housing 12 adapted for waterproof containment of a touch-screen tablet computer C or the like, e.g., an iPad®, smartphone, or similar device. Although a thin, flat housing 12 is shown in Figs. 1 and 2, this is not limiting. For example, the housing can have any suitable shape that improves functionality or ease of use. In one example, the housing may have ergonomic features, such as handles or contours that make the case easier to grip. The housing can be constructed from any suitable material or materials including metal, plastic, alloy, or composite. In some instances, positively buoyant plastics can be desirable. The housing can include surface coatings, such as non-slip materials, which make the case easier to grip.

In one example, the housing 12 can be formed of a rigid back panel 14, a rigid front frame or panel 16 opposite the back panel 14, mutually opposed rigid side panels 18, 20 extending between the back panel 14 and the front frame 16 to provide a space therebetween for the computer C, and an end panel 22. The various panels 14 through 22 can be imperviously sealed to each another by any suitable sealing technique (e.g., a cement or adhesive forming a watertight and fluid-tight seal), and can define an enclosure or internal volume 24 adapted for the placement of a touch-screen electronic device, such as the tablet computer C, therein. The various panels 14 through 22 may be formed of any suitably waterproof material of sufficient strength, and the panels 14 through 22 may be transparent, translucent, or opaque, as only the screen of the computer device C need be observed by the user of the case 10. For example, clear or translucent acrylic sheet material may be used to form the panels 14 through 22, although polycarbonate or any other suitable material can be used. The use of plastics provides for the transmission of radio frequencies therethrough, allowing the computer C contained within the case 10 to communicate with other devices through conventional means (e.g., Bluetooth®) often provided with such computers. Alternatively, the housing 12 may be formed as a unitary, monolithic structure by injection molding, blow molding, or other plastics manufacturing processes, or may be formed from composites or other non-corrosive materials by any conventional process. Accordingly, the housing can be formed from any suitable number of pieces ranging from one to many that are connected using any suitable manufacturing process or processes.

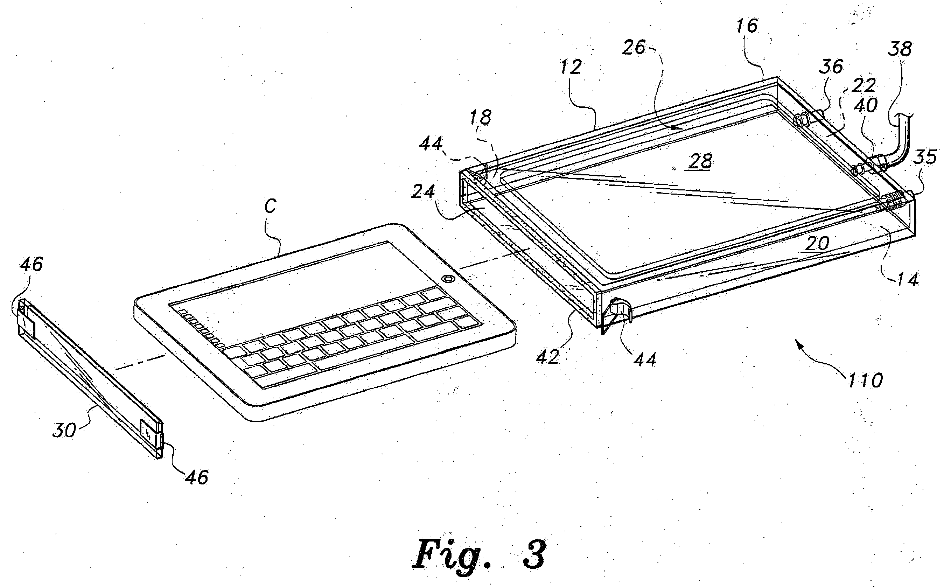

In one example, the front frame 16 includes a large opening 26 therethrough. The opening 26 is covered and sealed by a thin, flexible, transparent touch-screen operation membrane or panel 28. The flexible and transparent touch-screen panel 28 enables the user of the case 10 to apply pressure to any point on the membrane or panel 28 to contact the underlying portion of the touch-screen of the computer C, thereby operating the computer in its sealed case 10. A removable hatch or cover 30 may be provided opposite the fixed end panel 22, allowing the user of the case 10 to install and remove the computer C. Details of the removable hatch 30
are illustrated in Fig. 3 and discussed further below. Although the removable hatch or cover 30 is shown on a left-hand side of the device, this is not limiting. The removable hatch or cover can be located in any suitable location to allow for insertion and removal of the computer C into and from the case 10, respectively. For example, any side surface, top surface, or back surface can incorporate a removable hatch or cover to facilitate insertion and removal of the computer C. In another example, the case 10 can include a clamshell design without removable portions.

It will be recognized that submersion of the sealed case 10 to any appreciable depth will result in water pressure exerting a force upon the flexible panel or membrane 28, causing it to deflect inwardly into the internal volume 24 within the case 10. The panel or membrane 28 would, in turn, press upon the screen of a touch-screen computer device C sealed therein, and the uniform pressure developed over the entire screen surface would obviate the ability to apply any meaningful tactile input to the screen of the computer C, even though the computer is sealed from the water outside the case 10.

Accordingly, the case 10 is pressurized internally to counteract the external pressure developed by the water at the operating depth of the case. The case 10 may include a source of pressurized gas disposed upon one of the panels, e.g., the end panel 22, although the pressurized gas source may communicate with any of the panels 14 through 22 or the removable hatch 30 as desired. In the example of Figs. 1 and 2, the pressurized gas source is a small cartridge 32 of carbon dioxide (CO₂ of the type conventionally used for the inflation of life preservers and other inflatable devices. A regulator valve 34 is attached to the housing 12 and communicates with the internal volume 24 of the case 10, the cartridge 32 being removably attached to the regulator valve 34. The pressurized gas can include any suitable gas or gases, such as carbon dioxide, oxygen, air, nitrogen, argon, helium, etc., or any mixture of gases.

The regulator valve 34 is adjusted to provide an internal pressure within the case 10 that is slightly higher than the ambient water pressure at the working depth of the case. The user of the case 10 can easily adjust the pressure by means of the regulator valve 34 while observing the shape of the flexible panel or membrane 28. If too little pressure is provided to the internal volume 24 of the case 10, the panel 28 will be deflected inward onto the screen of
the computer C. If too great a pressure is provided, the panel or membrane 28 will be deflected outward due to the pressure differential between the internal volume 24 of the case 10 and the external water pressure. The user of the case 10 need only adjust the regulator periodically to cause the flexible panel or membrane 28 to deflect slightly outward from the case 10. The slightly greater pressure within the case 10 not only provides for proper operation of the touch-screen computer C within the case 10, but also prevents the inflow of water into the case 10 in the event of any slight leakage at any point.

Although manual adjustment of the internal case pressure is described, this is not limiting. The system can be more sophisticated. For example, an automatic pressure regulating system (not shown) can be incorporated into the case 10. The automatic pressure regulating system can include sensors (not shown) for determining deflection of the flexible panel or membrane 28, and pressure within the case 10 can be adjusted accordingly. For instance, if uniform inward deflection of the flexible panel or membrane 28 is detected, the automatic pressure regulating system can increase the pressure within the case 10 to prevent the flexible panel or membrane 28 from contacting the touch-screen of the computer C and rendering it inoperative. Conversely, if the uniform outward deflection of the flexible panel or membrane 28 is detected, the automatic pressure regulating system can decrease the pressure within the case 10 to prevent structural damage to the flexible panel or membrane 28 and to improve functionality and response to the user's tactile inputs. As a result of the automatic pressure regulating system, the user can freely change their depth in the water without having to manually adjust the pressure within the case.

In another example, the automatic pressure regulating system can include a first pressure sensor attached to an internal surface of the case 10 and a second pressure sensor attached to an external surface of the case 10. By comparing the signals from the two pressure sensors, the pressure regulating system can determine if pressure within the case should be increased or decreased. To accomplish this comparison of pressures, the automatic pressure regulating system can include a microprocessor capable of receiving input signals from various sensors and generating output commands based on those signals. For instance, the microprocessor can compare a first signal from the first pressure sensor and a second signal from the second pressure sensor. Based on this comparison, the microprocessor can send a command signal to the pressure regulator valve instructing it to open or close. Opening and closing of the valve can be accomplished with a servo motor or other suitable device.

The microprocessor can be an independent component. Alternately, the capability of the computer C can be leveraged as part of the pressure regulating system, thereby allowing the computer C to serve as the microprocessor for the pressure regulating system. Similarly, the pressure regulating system can leverage other features built into the computer, such as pressure or temperature sensors and battery power to operate sensors and indicator lights and to actuate pressure valves.

Although an automatic pressure regulating system having a microprocessor is described herein, this is not limiting. For example, mechanical devices capable of comparing two pressures and maintaining a desired pressure differential between the two pressures (i.e. internal and external housing pressures) can be used. This configuration, while mechanical in nature, can provide automatic pressure regulation that requires little or no manual control.

As the computer C is not pneumatically sealed, the gas pressure developed within the case 10 with the computer C sealed therein will result in the pressure within the computer C being equal to the pressure within the case 10, but outside of the computer C. Thus, no net pressure is developed on either side of the touch screen of the computer C. However, the slightly greater pressure within the case 10 relative to the external water pressure results in the flexible membrane or panel 28 being deflected away from the touch screen of the computer C contained within the case 10. Thus, a diver using the pressurized waterproof case 10 with the computer C sealed therein need only apply localized fingertip pressure to the flexible panel or membrane 28 to deflect it inward to the screen of the computer C, thereby controlling the computer C by means of its touch screen.

In one example, the case 10 can also include a pressure relief valve 36 disposed upon one of the panels of the case 10 that communicates with the internal volume 24 of the case. Such a pressure relief valve 36 is illustrated in Figs. 1 through 3 extending from the end panel 22, but
the valve 36 may be installed in any of the panels comprising the housing 12 of the case 10. The pressure relief valve 36 can be a one-way check valve that opens to release gas when gas pressure inside the case 10 is greater than external pressure applied by water, but precludes
the inflow of water into the case 10 should the external pressure be greater than the pressure
within the case 10 at any point. The pressure relief valve 36 is set to allow only a relatively
small differential pressure between the interior of the case 10 and the external pressure in order to preclude excessive distension of the flexible panel or membrane 28.

Fig. 3 of the drawings illustrates an alternative embodiment of the pressurized waterproof case, designated as case 110. The case 110 of Fig. 3 can be formed of the same panel components as the case 10 of Figs. 1 and 2, i.e., panels 14 through 22, and can have the opening 26 in the front frame or panel 16 sealed by the flexible panel or membrane 28. One difference between the case 10 of Figs. 1 and 2 and the case 110 of Fig. 3 is the source of pressurized gas used to provide gas pressure to the internal volume 24 of the case 110. An external line 38 is removably connected to a fitting 40 of the end panel 22 of the case 110 of Fig. 3 to deliver air or other gas to the case 110. A conventional manually activated button or other control may be provided to allow the user to add pressure to the case 110 as desired. Alternately, the addition of pressure can be controlled by the automatic pressure regulating system. The source of the gas may be the diver's breathing air, as provided by a pressure regulator to provide the desired pressure to the case 110 and a shutoff valve at the diver's air tank for use in the event of excessive airflow to the case 110. Such regulators and shutoff valves are conventional, and accordingly are not illustrated. Other sources of pressurized gas for the case 10 may be provided as desired, e.g., a separate, remotely disposed gas cylinder containing air, CO₂, etc., carried by the diver.

Fig. 3 also provides an illustration of one example of the removable hatch 30 for the cases 10 and 110. The hatch 30 and its mechanism shown in Figs. 2 and 3 are identical for the two cases 10 and 110 but is not limiting. The hatch 30 may be formed of material identical to or dissimilar to the materials used to form the remainder of the case 10, so long as it is rigid. A resilient waterproof seal 42, e.g., an O-ring, resilient flange, etc., is installed about the open end or edge of the case 10, the rigid hatch 30 clamping tightly against the resilient seal 42 to seal the computer C within the case 10 and to prevent water from entering therein. The slightly higher pressure within the case 10 also assists in preventing water entry, as noted further above, since any leakage would tend to be gas escaping from the case as opposed to water entering the case. The latching means used to secure the hatch 30 tightly to the case 10 may comprise an over-center type latch 44 disposed at the end of each of the side panels 18 and 20 adjacent the open end of the case 10, and cooperating catches 46 disposed upon the opposite ends of the hatch 30, or some other means of tightly securing the hatch 30 to the case 10 or 110, e.g., threaded hold-down bolts, snap-fit, or any other suitable mechanical joint.

As shown in Figs. 1-3, the case 10, 110 may also include a push button control assembly gland 35 extending through the housing 12 with a push button control rod or other push button assembly that will align with and operate an on/off power switch on the computer C so that the diver can power the electronic device on or off without removing the electronic device from the case. Similar features can be incorporated into the case to allow for other buttons, switches, or features of the computer to be operated without removing the device from the case.

In one example, the pressurized waterproof case 10 or 110 can be used by initially removing the hatch 30 from the remainder of the case, activating the computer C and setting any mechanical controls necessary, then placing the computer C within the case 10 or 110, and securing the hatch 30 in place. The air or other gas supply is then connected to the case 10 or 110, if not previously accomplished. The diver may then open the regulator slightly, e.g., regulator 34 for the case 10 of Figs. 1 and 2, and begin the dive. The diver may periodically adjust the regulator 34 as he or she descends in order to maintain a slightly greater pressure within the case 10, 110 than the pressure at the corresponding depth. Alternatively, the diver may elect to keep the regulator 34 closed until reaching the desired depth, and then open the regulator upon reaching the working depth in order to pressurize the case 110 slightly above the ambient pressure developed by the water at the working depth. It is recognized that the diver may ascend and/or descend to some degree during the dive, and the diver may adjust the pressure within the case 10 manually as needed in order to prevent the flexible transparent touch-screen operation panel 28 from bearing against the touch screen of the computer C contained within the case 10 or 110. Even the relatively small gas cartridge 32 of the case 10 embodiment of Figs. 1 and 2 provides sufficient gas for the duration of the dive, as the case 10 is sealed unless pressure therein exceeds external pressure to some predetermined degree. When the pressure is properly adjusted at a constant level, the relief valve 36 is closed and the pressure within the sealed case 10 is relatively constant with no additional gas being required to maintain the pressure. When the diver ascends, the relief valve 36 vents excessive pressure from the case 10 or 110, requiring no further operation on the part of the diver. Pressure will remain slightly above ambient within the case 10 or 110 even as the diver surfaces. The diver may then open the latches 44 and remove the hatch 30 of the case 10, 110 to retrieve the computer C from the case, and download or otherwise work conventionally with the data entered into the computer C during the dive.

The flexible membrane or panel 28 may be made from vinyl or any other suitable material that is substantially transparent and flexible. The case 10, 110 preferably is substantially fluid-tight, i.e., water cannot leak in, and the pressurized gas (carbon dioxide, air, oxygen, an inert gas, etc.) cannot leak out. The flexible membrane or panel 28 can be attached to the case 10, 110 using any suitable method such as, for example, ultrasonic welding. Alternately, suitable adhesives, mechanical fasteners, or a combination thereof can be used.

It is contemplated that the pressurized waterproof case may be provided as a dedicated device in combination with a tablet computer or the like for use underwater. In that situation, the tablet computer C can be permanently sealed inside the case 10, 110, which would no longer require the hatch 30. The case 10, 110 may be equipped with a regulator valve 34 adapted for connection to a source of pressurized gas, and with a relief valve 36 to release gas when the pressure inside the case 10, 110 exceeds ambient pressure by too much. The tablet computer C may be connected to fittings or connectors mounted in the rigid walls of the case 10, 110, e.g., a power adapter for charging the battery, a USB port, etc., the fittings or connectors being equipped with appropriate waterproof or fluid-tight seals.

The case can facilitate underwater communications, such as calling, text messaging, emailing, data transfers, or file sharing between the computer and any other device. The case 10 can include a communication device that enables through-water communication with any suitable underwater device or device at the surface (e.g. computer, submarine, submersible, dive watch, dive boat, sensor, unmanned surface vessel, acoustic underwater modem, etc.). In one example, a first case can facilitate communications between a first diver holding the first case and a second diver holding a second case, where the communication devices in the first and second cases are compatible. In another example, a first case can facilitate communications between a diver with the first case and a surface vessel, such as an unmanned surface vessel as described in U.S. Patent Application No. 61/648,886, filed on May 18, 2012 and titled "Satellite and Acoustic Tracking Device,". The diver can conduct underwater research, such as marine ecology or biology studies or bottom mapping studies, and transfer data resulting from the underwater research to the unmanned surface vessel, which can then store or transmit the data to an remote communication station on shore. In yet another example, a first case can facilitate communications from a diver holding a first case to a fixed underwater listening station including an acoustic transmitter and hydrophone array that are compatible with the communication device in the first case. The communication device can include separate components for transmitting and receiving signals, or the components can be integrated.

The communication device can include a component, such as an acoustic hydrophone, for receiving underwater acoustic communications. Acoustic hydrophones typically include a piezoelectric transducer that generates an electrical signal when subjected to a pressure change. A message, such as a call, text message, email, data, or file can be encoded by a microprocessor into an acoustic wave that can be transmitted by an acoustic transmitter through water to a hydrophone. In response to receiving the acoustic wave, the hydrophone can output an electrical signal that can be decoded by a microprocessor. To function properly, the hydrophone should be exposed to the water through which it is receiving acoustic waves. Therefore, if the case includes a hydrophone, a first portion of the hydrophone should extend from the case into the water. A second portion of the hydrophone, such as the end from which an electrical signal is output, can be housed within the case for protection.

The communication device can include a component, such as an acoustic transmitter, for transmitting underwater acoustic communications. The acoustic transmitter should be exposed to the water through which it is transmitting acoustic waves. Therefore, if the case includes an acoustic transmitter, a first portion of the acoustic transmitter should extend from the case into the water. A second portion of the acoustic transmitter, such as the end where an electrical signal is input, can be housed within the case for protection.

As described above, at least a portion of the communication device can be housed within the case and can be connected to the computer, where "connected" can include a wired connection or a wireless connection, such as Bluetooth or any other suitable method for exchanging data over short distances within the case. Any communications transmitted or received from the computer to the communication device can be recorded, time stamped, or geocoded.

The computer can include an input for a speaker and microphone that allows the user to communicate verbally with other divers via the computer and communication device. For example, the computer can include an input for a push to talk (PTT) system where the user presses a microphone button to talk to other divers and releases the button to listen to other divers. In one example, the PTT system can be integrated into the diver's mask. The computer can be configured to record communications, thereby enhancing underwater data acquisition.

The case 10 can include a variety of sensors to promote safety and enhance data acquisition. For example, the case 10 can include pressure sensors, depth sensors, temperature sensors, salinity sensors, force sensors, vibration sensors, photo optic sensors, fluid property sensors, and/or position sensors. The sensors can be connected to the microprocessor located within the case. Alternately, the sensors can be connected to the computer C. Those skilled in the art will appreciate that any other necessary components required for data acquisition can be included as separate components in the case 10 or incorporated directly into the computer C.

The computer can be configured to run software applications. In one example, a software application can enable a guided tour of underwater features. The user can arrive at a location of interest and enter the water with the case described herein. The user can run the software application on the computer C. The user can manually input their diving location. Alternately, the computer can determine the user's geographical location based on GPS, triangulation, or any other suitable method. Once the user's location has been determined, the software application can load a guided tour based on the user's location. For example, a guided tour may direct the user to noteworthy objects and sites such as shipwrecks and reefs. The software application can also provide flora and fauna guides that are easily accessible and tailored to the user's location.

The computer can receive location-based information from a GPS receiver located within or attached to the case or from a GPS receiver within the computer. GPS is a satellite-based navigation system made up of a network of 24 satellites placed into orbit by the U.S. Department of Defense. Civilian GPS uses a frequency of 1575.42 MHz in the UHF band. The radio signals can pass through clouds, glass, and plastic, but cannot pass through most solid objects, such as buildings or mountains. When passing through liquids, such as seawater, the radio signals are heavily attenuated. Consequently, the GPS receiver will only function when the case is above water. When the case is below water, the computer can still receive location-based information through the communication device via acoustic waves. For example, location-based information can be acquired by a GPS receiver located above the surface of the water, and that location-based information can be encoded and transmitted to the case located underwater via acoustic waves.

Although usage in an underwater environment is primarily described herein, this case can also be used in other environments where data recordation is desired but where ambient pressure and natural elements are limiting factors. For example, this apparatus could be used in mountainous terrain at high elevations where precipitation, such as snow, is common.

It is to be understood that the present invention is not limited to the embodiments described above, but encompasses any and all embodiments within the scope of the following claims.

## Claims

1. A thud-tight case (10) for a touch-screen electronic device, comprising:
a housing (12) that is substantially fluid-tight;
a flexible panel (28) on a surface of the housing (12) configured to allow operation of a touch screen of an electronic device located within the housing (12); and
a regulator valve (34) connected to the housing (12), wherein the regulator valve (34) is configured to admit pressurized gas into the housing (12) to space the flexible panel away from the touch screen.

2. The fluid-tight case of claim 1, further comprising an automatic pressure regulating system configured to control the regulator Valve (34).

3. The fluid-tight case of claim 2, wherein the automatic pressure regulating system comprises: a first pressure sensor connected to an internal surface of the housing (12); and a second pressure sensor connected to an external surface of the housing (12).

4. The fluid-tight case of claim 1, further comprising a touch-screen electronic device within the housing (12).

5. The fluid-tight case of claim 4, wherein the touch-screen electronic device comprises a software application configured to provide underwater tours.

6. The fluid-tight case of claim 4, wherein the software application is configured to select an underwater tour based on a geographical location of the electronic device.

7. The fluid-tight case of claim 5, wherein the software application is configured to provide alerts to a user.

8. The fluid-tight case of claim 1, wherein the flexible panel comprises vinyl.

9. The fluid-tight case of claim 4, further comprising a hatch configured to allow for removal of the touch-screen electronic device from the housing (12).

10. The fluid-tight case of claim 1, further comprising a pressure sensor,
temperature sensor, depth sensor, GPS receiver, or salinity sensor attached to the housing (12).

11. The fluid-tight case of claim 1, further comprising a communication device attached to the housing (12).

12. The fluid-tight case of claim 11, wherein the communication device is configured to transmit or receive acoustic signals.

13. The fluid-tight case of claim 12, wherein the communication device is connected to a touch-screen electronic device.

14. The fluid-tight case of claim 13, wherein the touch-screen electronic device is configured to send or receive text messages, emails, data, or files using the communication device.

## Patentansprüche

1. Flüssigkeitsdichtes Etui (10) für eine elektronische Touchscreenvorrichtung, umfassend:
ein Gehäuse (12), das im Wesentlichen flüssigkeitsdicht ist;
eine flexible Bahn (28) auf einer Oberfläche des Gehäuses (12), die konfiguriert ist, um die Bedienung eines Touchscreens einer elektronischen Vorrichtung zu ermöglichen, die sich innerhalb des Gehäuses (12) befindet, und
ein Regulierventil (34), das mit dem Gehäuse (12) verbunden ist, wobei das Regulierventil (34) konfiguriert ist, um unter Druck stehendes Gas in das Gehäuse (12) einzulassen, um die flexible Bahn von dem Touchscreen zu beabstanden.

2. Flüssigkeitsdichtes Etui nach Anspruch 1, ferner umfassend ein automatisches Druckreguliersystem, das zur Regelung des Regulierventils (34) konfiguriert ist.

3. Flüssigkeitsdichtes Etui nach Anspruch 2, wobei das automatische Druckreguliersystem umfasst: einen ersten Drucksensor, der mit einer Innenfläche des Gehäuses (12) verbunden ist, und einen zweiten Drucksensor, der mit einer Außenfläche des Gehäuses (12) verbunden ist.

4. Flüssigkeitsdichtes Etui nach Anspruch 1, ferner umfassend eine elektronische Touchscreenvorrichtung innerhalb des Gehäuses (12).

5. Flüssigkeitsdichtes Etui nach Anspruch 4, wobei die elektronische Touchscreenvorrichtung eine Softwareanwendung umfasst, die zur Bereitstellung von Unterwassertouren konfiguriert ist.

6. Flüssigkeitsdichtes Etui nach Anspruch 4, wobei die Softwareanwendung konfiguriert ist, um basierend auf einer geographischen Position der elektronischen Vorrichtung eine Unterwassertour auszuwählen.

7. Flüssigkeitsdichtes Etui nach Anspruch 5, wobei die Softwareanwendung konfiguriert ist, um einem Anwender Alarmmeldungen bereitzustellen.

8. Flüssigkeitsdichtes Etui nach Anspruch 1, wobei die flexible Bahn Vinyl umfasst.

9. Flüssigkeitsdichtes Etui nach Anspruch 4, ferner umfassend eine Klappe, die konfiguriert ist, um die elektronische Touchscreenvorrichtung aus dem Gehäuse (12) entfernen zu können.

10. Flüssigkeitsdichtes Etui nach Anspruch 1, ferner umfassend einen Drucksensor, Temperatursensor, Tiefensensor, GPS-Empfänger oder einen Salzgehaltsensor, die an dem Gehäuse (12) angebracht sind.

11. Flüssigkeitsdichtes Etui nach Anspruch 1, ferner umfassend eine Kommunikationsvorrichtung, die an dem Gehäuse (12) angebracht ist.

12. Flüssigkeitsdichtes Etui nach Anspruch 11, wobei die Kommunikationsvorrichtung konfiguriert ist, um akustische Signale zu übertragen oder zu empfangen.

13. Flüssigkeitsdichtes Etui nach Anspruch 12, wobei die Kommunikationsvorrichtung mit einer elektronischen Touchscreenvorrichtung verbunden ist.

14. Flüssigkeitsdichtes Etui nach Anspruch 13, wobei die elektronische Touchscreenvorrichtung zum Senden oder Empfangen von Textnachrichten, E-Mails, Daten oder Dateien unter Verwendung der Kommunikationsvorrichtung konfiguriert ist.

## Revendications

1. Boîtier étanche aux fluides (10) pour dispositif électronique à écran tactile, comprenant :
un logement (12) qui est sensiblement étanche aux fluides ;
un panneau souple (28) sur une surface du logement (12) configuré pour permettre l'actionnement d'un écran tactile d'un dispositif électronique situé dans le logement (12) ; et
une vanne de régulation (34) connectée au logement (12), où la vanne de régulation (34) est configurée pour admettre du gaz sous pression dans le logement (12) afin d'écarter le panneau souple de l'écran tactile de l'écran tactile.

2. Boîtier étanche aux fluides selon la revendication 1, comprenant en outre un système de régulation automatique de la pression configuré pour contrôler la vanne de régulation (34).

3. Boîtier étanche aux fluides selon la revendication 2, dans lequel le système de régulation automatique de la pression comprend : un premier capteur de pression connecté à une surface interne du logement (12) et un second capteur de pression connecté à une surface externe du logement (12).

4. Boîtier étanche aux fluides selon la revendication 1, comprenant en outre un dispositif électronique à écran tactile à l'intérieur du logement (12).

5. Boîtier étanche aux fluides selon la revendication 4, dans lequel le dispositif électronique à écran tactile comprend une application logicielle configurée pour proposer des circuits de visites subaquatiques.

6. Boîtier étanche aux fluides selon la revendication 4, dans lequel l'application logicielle est configurée pour sélectionner un circuit de visite subaquatique en se basant sur une position géographique du dispositif électronique.

7. Boîtier étanche aux fluides selon la revendication 5, dans lequel l'application logicielle est configurée pour délivrer des alertes à un utilisateur.

8. Boîtier étanche aux fluides selon la revendication 1, dans lequel le panneau souple comprend du vinyle.

9. Boîtier étanche aux fluides selon la revendication 4, comprenant en outre une trappe configurée pour permettre le retrait du dispositif à écran tactile du logement (12).

10. Boîtier étanche aux fluides selon la revendication 1, comprenant en outre un capteur de pression, un capteur de température, un capteur de profondeur, un récepteur GPS ou un capteur de salinité rattachés au logement (12).

11. Boîtier étanche aux fluides selon la revendication 1, comprenant en outre un dispositif de communication rattaché au logement (12).

12. Boîtier étanche aux fluides selon la revendication 11, dans lequel le dispositif de communication est configuré pour transmettre ou recevoir des signaux acoustiques.

13. Boîtier étanche aux fluides selon la revendication 12, dans lequel le dispositif de communication est connecté à un dispositif électronique à écran tactile.

14. Boîtier étanche aux fluides selon la revendication 13, dans lequel le dispositif électronique à écran tactile est configuré pour envoyer ou recevoir des messages de texte, des courriels, des données ou des fichiers au moyen du dispositif de communication.
